# EUROPÄISCHE PATENTSCHRIFT

(11) **EP 1 097 262 B1**
(45) Veröffentlichungstag und Bekanntmachung des Hinweises auf die Patenterteilung: **21.08.2002**
(21) Anmeldenummer: 99939958.7
(22) Anmeldetag: 23.06.1999
(51) Int. Cl.: C30B 9/00, C30B 29/46, C30B 29/48

(54) **EINKRISTALLPULVER- UND MONOKORNMEMBRANHERSTELLUNG**
MONOCRYSTALLINE POWDER AND MONOGRAIN MEMBRANE PRODUCTION
PRODUCTION D'UNE POUDRE MONOCRISTALLINE ET D'UNE MEMBRANE MONOGRAIN

(30) Priorität: 25.06.1998 DE 19828310
(43) Veröffentlichungstag der Anmeldung: 09.05.2001
(73) Patentinhaber: Forschungszentrum Jülich GmbH, 52425 Jülich (DE)
(72) Erfinder: MEISSNER, Dieter, A-4040 Linz (AT); MELLIKOV, Enn, EE3400 Saku (EE); ALTOSAAR, Mare, EE0026 Tallin (EE)
(86) Internationale Anmeldenummer: DE9901870
(87) Internationale Veröffentlichungsnummer: WO99067449

(56) Entgegenhaltungen:
- EP-A- 0 173 641
- WO-A-89/05280
- US-A- 3 174 823
- ALTOSAAR ET AL: "monograin layers and membranes for photovoltaics" CONF. RECORD OF THE 25TH IEEE PHOTOVOLTAIC SPECIALISTS CONFERENCE , 13. - 17. Mai 1996, Seiten 877-880, XP002121609 washinton DC USA

## Beschreibung

Die Erfindung betrifft ein Verfahren zur Herstellung von Einkristallpulvern und eine hieraus bestehende Monokornmembran.

Eine Monokornmembran ist eine dünne Schicht, die aus einer Lage eines Pulvers aufgebaut ist. Die Pulverkörner sind miteinander verklebt.

Aus der Druckschrift "T. S. Velde, G. W. M. T. van Helden, Monograin layers, Philips Technical Review, 29 (1968), 238 - 242" ist bekannt, aus einkristallinem CdS-Pulver eine Monokornmembran herzustellen. Einkristallines, aus CdS bestehendes Pulver wird durch Zerkleinern eines größeren Einkristalls hergestellt. Es wird dann ein Klebstoff als dünne Schicht auf einem aus Glas bestehenden Substrat aufgebracht. Auf die, aus dem Klebstoff bestehende, Schicht wird das Pulver aufgestreut. Eine Lage des Pulvers haftet daraufhin am Klebstoff. Die übrigen, nicht mit dem Klebstoff verbundenen Pulverkörner werden entfernt. Gelöstes Harz, Polymer oder Komponenten hierfür werden zu den am Klebstoff haftenden Pulverkörnern hinzugegeben. Nach Trocknen und Aushärten der Lösung wird die, eine Pulverlage enthaltende, Schicht vom Substrat abgezogen. Durch Ätzen können die Pulverkörner bei Bedarf von der Oberfläche her freigelegt werden. Im übrigen sind bzw. bleiben die Pulverkörner durch das Harz etc. miteinander verbunden und bilden so die gewünschte Monokornmembran.

Problematisch ist die Herstellung des einkristallinen Pulvers. So ist es relativ teuer, zunächst einen größeren Einkristall herzustellen. Auch ist es kaum möglich, durch mechanisches Zerkleinern gleichmäßig große Pulverkörner herzustellen. Gleichmäßig große Pulverkörner sind erforderlich, um zu einer gleichmäßig dicken Monokornmembran zu gelangen.

Aus Altosaar et al., "Monograin layers and membranes für photovoltaics", Conf. record of the 25^{th} IEEE Photovoltaic Specialists Conference, 13.-17. Mai 1996, Seiten 877-880, Washington DC USA, ist ein Verfahren zur Herstellung eines einkristallinen, aus einem Halbleitermaterial bestehenden Pulvers bekannt. Die nicht kristallinen Ausgangsstoffe werden zunächst in einem Flußmittel aufgeschmolzen, und anschließend herauskristallisiert. Die Korngröße des Pulvers liegt im Bereich von 30 bis 80 mm. Aus diesem Pulver läßt sich auch eine Monokornmembran herstellen.

Eine Monokornmembran kann unter anderen auf dem Gebiet der Photovoltaik vorteilhaft eingesetzt werden. Ein dann besonders gut geeignetes Material ist Kupfer-Indium-Diselenid.

Aufgabe der Erfindung ist Schaffung eines preiswerten Herstellungsverfahrens für einkristallines Pulver mit vorgegebenen Korngrößen. Aufgabe der Erfindung ist ferner die erstmalige Bereitstellung bestimmter Monokornmembranen aus verfahrensgemäß erzeugten Pulvern.

Die Aufgabe wird durch ein Verfahren mit den Merkmalen des Hauptanspruchs gelöst. Vorteilhafte Ausgestaltungen ergeben sich aus dem abhängigen Anspruch.

Verfahrensgemäß wird eine Schmelze erzeugt und ein Flußmittel zugegeben. Die Schmelze wird aus den einzelnen Komponenten eines Halbleitermaterials, zum Beispiel aus den Komponenten von Kupfer-Indium-Diselenid oder GaAs erzeugt, wobei wenigstens eine Komponente ein Element der 11. IUPAC-Gruppe ist. Anstelle der Komponenten können auch Salze aufgeschmolzen werden, die die Komponenten beinhalten. Die Komponenten oder ihre Salze werden bevorzugt so gewählt, daß die Komponenten in der Schmelze gemäß der stöchiometrischen Zusammensetzung des herzustellenden Pulvers vorliegen.

Die Schmelze ist dann auf eine Temperatur zu bringen, bei der die einzelnen Komponenten oder ihre Salze schmelzen und zugleich das herzustellende Pulver auskristallisiert. Eine solche Temperatur liegt typischerweise zwischen 300 °C und 1000 °C. Im geeigneten Temperaturbereich entstehen einkristalline Pulverkörner in der Schmelze. Weisen die Pulverkörner die gewünschte Größe auf, so wird die Schmelze so stark abgekühlt oder abgeschreckt, daß hierdurch das Wachstum der Pulverkörner unterbrochen wird. Der geeignete Zeitpunkt des Abschreckens sowie der geeignete Temperaturverlauf zur Erzielung gewünschter Pulvergrößen werden z. B. durch Vorversuche ermittelt. Nach dem Abkühlen bzw. Abschrecken ist es zweckmäßig, das Flußmittel zu entfernen.

Das Verfahren ist einfach und preiswert, da keine großen Einkristalle zuvor hergestellt werden müssen. Die Körner wachsen gleichmäßig, so daß das entstehende Pulver aus gleichmäßig großen Körnern besteht.

Zur Herstellung von Kupfer-Indium-Diselenid-Einkristallpulver kann die Salzschmelze aus CuSe und In oder Cu, Se, In oder Cu-In-Legierungen und Se oder Cu-, In- oder Se-Salzen mit geeigneten Schmelzpunkten erzeugt worden sein. Eine typische Schmelze setzt sich dann zum Beispiel aus 6.35 g Cu, 11.5 g In, 15.8 g Se und 40 Vol.-% CuSe zusammen.

Als Flußmittel können NaCl oder ein Überschuß Se oder Selenide in einer Kupfer-Indium-Diselenid-haltigen Schmelze eingesetzt werden. Der Anteil des Flußmittels beträgt typischerweise 40 Vol.-% der Schmelze. Er kann jedoch allgemein zwischen 10 Vol.-% und 90 Vol.-% liegen. Die Schmelze wird zusammen mit dem Flußmittel zum Beispiel in eine Quarzampulle gefüllt. Die Quarzampulle wird evakuiert und abgeschmolzen. Dann wird die Quarzampulle zusammen mit dem beispielhaft angegeben Inhalt auf wenigstens 300 °C, insbesondere auf 600 °C aufgeheizt. Sobald die Komponenten geschmolzen sind, wachsen einkristalline Kupfer-Indium-Diselenid-Körner heran. Das Wachstum eines Halbleiters, wie zum Beispiel Kupfer-Indium-Diselenid erfolgt in Abhängigkeit von der Zeit und dem eingesetzten Flußmittel. Je nach Flußmittel und gewünschter Größe der Pulverkörner ist eine Behandlungszeit von 5 Minuten bis 100 Stunden erforderlich.

Um das Wachstum gezielt zu unterbrechen, wird die Schmelze abgekühlt. Die Abkühlrate bestimmt den Defektgehalt und die Defektart im Material sowie die Oberflächenmorphologie. Das Quenchen kann innerhalb von wenigen Sekunden erfolgen. Die Schmelze kann auch über mehrere Stunden hinweg abgekühlt werden. Hierfür kann die Quarzampulle zusammen mit dem Inhalt zu einem durch Vorversuche ermittelten Zeitpunkt in einem Wasserbad oder in Luft abgekühlt werden. Anschließend wird der Inhalt der Quarzampulle entnommen und das Flußmittel entfernt. Im Fall von NaCl kann dies zum Beispiel durch Auflösen von NaCl in Wasser geschehen, wenn die Pulverkörner wie im Fall von Kupfer-Indium-Diselenid in Wasser unlöslich sind. Wird Se als Flußmittel eingesetzt, so kann dieses durch Verdampfen von Se entfernt werden.
Der Temperaturbereich, in dem die Rekristallisation durchgeführt wird, hängt vom Flußmittel und der gewünschten Korngröße ab und kann zwischen 100 °C und 1000 °C liegen. Durch das Verfahren wurde unter anderem einkristallines Kupfer-Indium-Diselenid-Pulver mit sehr hoher elektrischer Leitfähigkeit hergestellt. Der Körnerdurchmesser betrug zum Beispiel 40 µm. Die Körner wiesen einen Widerstand von 10 bis 30 Ω auf. Diese Werte entsprechen spezifischen elektrischen Widerständen von 0,1 bis 0,6 Ωcm.

Herstellbar waren Pulver mit Durchmessern von 0,1 µm bis 0,1 mm.

Aus den verfahrensgemäß hergestellten Pulvern lassen sich gemäß dem eingangs genannten Stand der Technik Monokornmembranen herstellen, die zum Beispiel in der Photovoltaik eingesetzt werden können. Zur Herstellung von Monokornmembranen war ein Mindestdurchmesser von 10 µm erforderlich, da andernfalls kein geschlossener Polymerfilm möglich war. Ein Durchmesser von 50 µm soll für die Herstellung von Monokornmembranen nicht überschritten werden, da andernfalls zum Beispiel auf dem Gebiet der Photovoltaik unerwünscht hohe Serienwiderstände auftreten und Material verschwendet wird. Hervorzuheben ist, daß die verfahrensgemäß hergestellten Korngrößen innerhalb einer Charge sich nur wenig unterschieden.

Weitere Beispiele für Halbleitermaterialien, aus denen verfahrensgemäß Einkristallpulver hergestellt werden können, sind CdTe, CdSeTe, CdS, CdSSeTe, GaAs, InP.

## Patentansprüche

1. Verfahren zur Herstellung eines einkristallinen, aus Halbleitermaterial bestehenden Pulvers, umfassend ein Mehrstoffsystem aus mindestens drei Komponenten, wobei eine Komponente ein Element der 11. IUPAC-Gruppe ist,
mit den Schritten:
a) die entsprechenden Komponenten des Halbleitermaterials oder deren Salze werden mit einem Flußmittel gemischt;
b) es wird eine Temperatur eingestellt, die oberhalb des Schmelzpunktes des Flußmittels und unterhalb des Schmelzpunktes des herzustellenden einkristallinen Pulvers liegt;
c) das einkristalline Pulver kristallisiert aus;
d) die Schmelze wird zwecks Unterbrechung des Wachstums des einkristallinen Pulvers abgekühlt.

2. Verfahren nach vorhergehendem Anspruch,
**gekennzeichnet durch**
Cu als ein Element der 11. IUPAC-Gruppe.

## Claims

1. A method of producing a monocrystalline powder consisting of semiconductor material, comprising a multi-substance system composed of at least three components, wherein one component is an element of IUPAC Group 11, comprising the following steps:
a) the corresponding components of the semiconductor material or salts thereof are mixed with a flux;
b) a temperature is set which is above the melting point of the flux and below the melting point of the monocrystalline powder to be produced;
c) the monocrystalline powder is crystallised out;
d) the melt is cooled for the purpose of discontinuing the growth of the monocrystalline powder.

2. A method according to the preceding claim,
**characterised by**
Cu as an element of IUPAC Group 11.

## Revendications

1. Procédé de préparation d'une poudre monocristalline constituée d'une matière semiconductrice, comprenant un système à plusieurs constituants d'au moins trois composants, dans lequel un composant est un élément du 11ème groupe IUPAC, avec les étapes :
a) les composants correspondants de la matière semiconductrice ou leurs sels sont mélangés à un fondant;
b) une température est ajustée, qui se trouve au-dessus du point de fusion du fondant et au-dessous du point de fusion de la poudre monocristalline à préparer;
c) la poudre monocristalline se cristallise;
d) la masse fondue est refroidie afin d'interrompre la croissance de la poudre monocristalline.

2. Procédé selon la revendication précédente, **caractérisé par** Cu en tant qu'élément du 11ème groupe IUPAC.
